# EUROPEAN PATENT SPECIFICATION

(11) **EP 1 084 790 B1**
(45) Date of publication and mention of the grant of the patent: **29.01.2003**
(21) Application number: 00122960.8
(22) Date of filing: 01.05.1997
(51) Int. Cl.: B23K 35/26, B23K 35/14, H05K 3/34

(54) **A solder composition**
Weichlötzusammensetzung
Composition de soudure tendre

(30) Priority: 10.05.1996 US 644765
(43) Date of publication of application: 21.03.2001
(62) Divisional of application: 97918275.5
(73) Proprietor: FORD MOTOR COMPANY LIMITED, Brentwood, Essex CM13 3BW (GB); Ford Motor Company, Dearborn, MI 48124 (US)
(72) Inventor: Parachuri, Mohan R., Canton, Michigan 48187 (US); Shangguan, Dong Kai, Livonia Michigan 48152 (US); Achari, Achyuta, Canton, Michigan 48188 (US)
(74) Representative: Messulam, Alec Moses

(56) References cited:
- WO-A-94/27777
- US-A- 4 657 589
- US-A- 5 229 070
- US-A- 5 328 521
- US-A- 5 382 300
- US-A- 5 415 944
- US-A- 5 429 293

## Description

This invention relates to a solder composition and more particularly to the use of a multi-component solder paste that has a low melting eutectic first component and a high melting second component that does not melt but does react with the eutectic component during reflow soldering of electronic components or packages to a metallised surface of a thermoplastic or polymer substrate to thereby form a solder interconnect that has a melting temperature higher than the reflow soldering temperature.

In microelectronic packaging, reflow soldering is one of the last steps in the assembly of the package. The assembly is usually comprised of a substrate prepared with surface metallisation to receive components; the components are constructed with pins, leads or surface metal pads for mounting to the surface metallisation of the substrate. Reflow soldering is a specialised type of soldering using a solid powder in a paste form; the solder paste is deposited at the joint of an assembly to be soldered and the assembly is thereafter heated, such as in an oven to reflow the solder paste as a fluid which, upon cooling, forms a metallurgical bond with the parts to be joined. Reflow soldering is predominately used to attach components to printed circuit boards because of component density, process ease, and improved through-put.

If the circuit board or substrate is comprised of a low cost thermoplastic material (such as polypropylene (PP), nylon, polycarbonate (PC), acrylonitrile-butadiene-styrene (ABS), polyethylene terephthalate (PET), polypropylene oxide (PPO), or polymethylstyrene (PS)), the chemistry of the solder must be modified to form a reliable solder joint during reflow soldering at a temperature below the heat deflection temperature of such thermoplastic material to avoid damage to such substrate. The heat deflection temperature of such plastic (defined herein to mean the temperature at which a specified deflection occurs in a plastic exposed to a relatively low stress level under controlled conditions) is usually in the range of 100-150°C. Eutectic solder compositions are known which will melt at such lower temperatures; examples of such solders include Sn-Bi (melting at 139°C), Sn-In (melting at 118°C), and Sn-Bi-In (having eutectics melting respectively at 77.5°C, 59°C and 56.5°C). Unfortunately, such lower melting eutectic solders will either melt or significantly soften when exposed to high service temperatures and, as such, the solder interconnect can be completely ruptured under thermomechanical loading in service.

Therefore there is a need to design a solder and devise a fabrication technique using such solder, that forms a solder joint between the component and substrate at a temperature below the heat deflection temperature of the thermoplastic substrate, but which solder has a post-reflow solder melting temperature which is much higher to preserve the mechanical integrity of the assembly particularly in an automotive service application. To satisfy each such requirement, the solder must possess multiple components that are different in composition and melting temperature.

Two component solders that have been used by the prior art have been designed to accelerate the wetting of the joint area by early melting of one or more low temperature components, but requires all components to fully melt during completion of the reflow soldering process. Sometimes the reflow soldering may take place in stages where the low temperature component is melted in a first stage, and then a second reflow soldering stage is undertaken to melt the high temperature component and thereby complete the total reflow soldering sequence. In all of the above circumstances, such solders fail to provide both a low temperature reflow melting temperature (below that of the heat deflection of the thermoplastic substrate.) and a post reflow melting temperature (well above the heat deflection temperature of the substrate) that is never experienced during fabrication or service.

The invention, in a first aspect, is a solder composition formed as a paste by use of a fugitive carrier medium including up to 5-15% (by weight of the composition) flux as defined in claim 1.

The invention in another aspect is a method of interconnecting electronic components and packages to circuits on a substrate by reflow soldering, the substrate being comprised of a low cost thermoplastic or polymer having a pre-determined heat deflection temperature. The method comprises the steps of: (a) applying the solder paste as defined in anyone of claims 1-5 onto a faying surface of the substrate circuit; and (b) heating the assembly to a temperature above the melting point of the low temperature eutectic powder to react Sn with the melted eutectic to form solid solutions intermetallics and thereby raise the post reflow soldering temperature of the solder to improve mechanical properties of the soldered joint when in service.

The invention will now be described, by way of example, with reference to the accompanying drawings, in which:
Figure 1 is a ternary phase diagram of the Sn-Bi-In alloy system illustrating the eutectics useful as the low melting component of the solder compositions;
Figure 2 is a highly enlarged schematic illustration of a solder connection made in accordance with this invention;
Figure 3 is a schematic diagram of the multi-component solder material of this invention illustrating its condition prior to reflow heating;
Figure 4 is a schematic diagram, similar to that of Figure 3, illustrating the solder material condition during and as a result of the reflow heating; and
Figure 5 is a schematic diagram similar to Figure 3, illustrating one of the possible microstructures in the solder after completion of reflow heating and cooling.

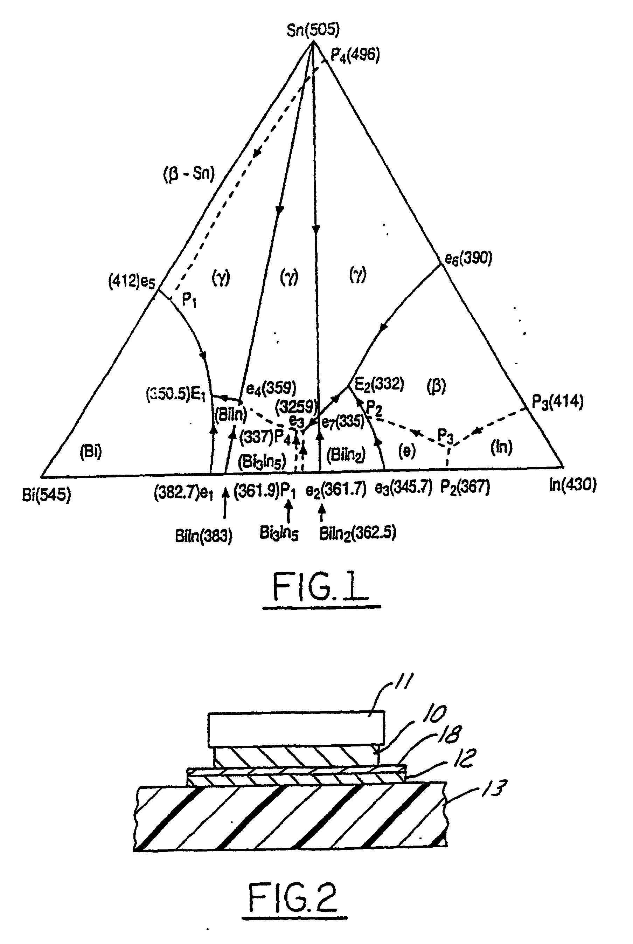

In a preferred embodiment as shown in Figure 2, a solder paste 10 in accordance with this invention is employed to form a tin-based essentially lead-free solder connection for mounting electronic components or packages 11 onto a printed circuit or metallised surface 12 of a thermoplastic or polymer substrate 13.

The substrate is preferably selected from PP, nylon, PC, ABS, PET, PPO and PS plastics, each of which present the problem solved by this invention. Each of these examples has a heat deflection temperature which is in the range of 100-150°C. It is important that during reflow soldering, temperatures should not be experienced that will exceed such heat deflection temperature.

Particularly in automotive applications, solders for electronic interconnects must possess certain mechanical and physical properties after the soldering steps have been completed. The interconnect must withstand higher temperatures due to subsequent processing or due to service temperatures under which, the assembly is used. The solder should not soften under thermomechanical loading in service, otherwise the electronic connects can be ruptured.

A soldering paste according to this invention that will reflow at 150°C or lower and yet achieve a higher post reflow soldering melting temperature, comprises intermixed powder components and a fugitive carrier and fugitive flux. One powder component 15 is a low temperature melting eutectic or alloy of the Sn-Bi-In system and the second component 16 is a high temperature melting powder metal selected from Sn or alloys of Sn-3.5% Ag, or Sn-10% In-9.5% Bi-0.5% Ag (by weight). The multi-component may also contain up to 3 wt.% other alloying elements selected from the group of Cu, Ni, Ag, Ce, In, Bi and Au; such elements should be selected to enhance the mechanical properties of the solder joint at elevated temperatures as long as they do not inhibit metallurgical interactions of the first and second powders (at or less than 150°C in 15 minutes or less). The weight ratio of the first eutectic component to the second component range from 3:1 to 1:3; i.e., the weight % of the first component to the solder can be 25-75%. The powders are sized to a mesh of -200/ +325 and contain no more than 0.1% by weight lead. Such paste has the powder components dispersed in a liquid vehicle or carrier 17 that contains a flux. One advantage of paste is that it may be conveniently applied to the faying surface 18, for example by stencil printing. After the faying surfaces are arranged in contact with the paste, the assembly is heated to melt the eutectic powder component, whereupon the partly molten solder coalesces to form a liquid body sufficient to complete the interconnect.

In order to obtain a strong bond, it is essential that the molten solder flow in intimate contact onto the faying surfaces 18, which phenomena is referred to as wetting. Wetting is enhanced by the presence of the flux, which reacts to remove oxides from the metal surfaces, particularly the faying surfaces. The flux (or flux paste as it is sometimes called) may be comprised of one or more solvents such as high boiling point alcohol, glycol or water, activators such as a rosin or synthetic resin components, weak organic acids, ethoxylated amide compounds, fatty amide compounds, and halides. It may also contain a small percentage of surfactants. The solvents will escape during the reflow heating stage through volatilisation, decomposition or reaction. Depending on the nature of the flux, the flux residue can either be removed during the subsequent cleaning steps or be left on the board for the life of the product.

Other techniques for applying the solder paste can be used such as screen printing, syringe dispensing, ink jet printing. An alternative method is to coat the second component onto one or both of the parts to be joined and then apply the first component in a paste form.

Figure 1 shows the various ternary and binary eutectics of the alloy system Sn-Bi-In. Melting temperatures for the eutectics (shown in parentheses) are in degrees Kelvin. When the low temperature powder component is a ternary eutectic, such as E₁ having a melting temperature of 77.5°C, and the high temperature powder component is pure Sn having a melting temperature of 232°C, the intermixed powders will have a reflow melting temperature of about 120°C and a post reflow melting temperature of about 160-180°C, provided the weight ratio between the powders is in the range of 3:2 to 2:3. The differential between the reflow and post-reflow melting temperatures is due to the interaction between unreflowed powder particles and melted powder which forms a single mass consisting of solid solutions 20 and intermetallics 21.

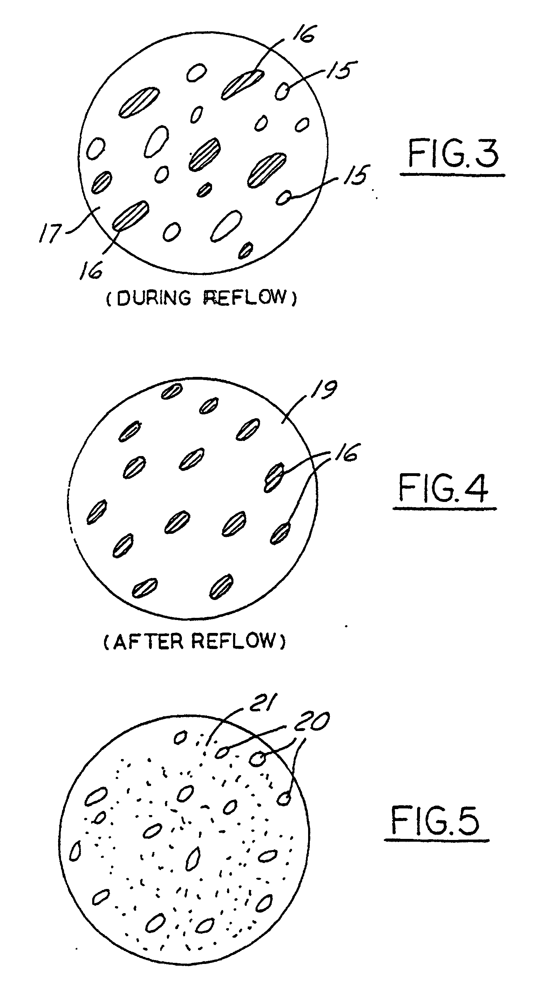

As shown in Figure 3, prior to reflow heating the powder particles 15 (low temperature powder) can be clearly distinguished as independent, but uniformly mixed with the powder particles 16 (high temperature component), in a carrier or solvent along with the flux. Notice that the particles size of each of the powders will vary (-200/ +325 mesh). During reflow heating (see Figure 4), the low temperature particles will melt and form a liquid 19 and the carrier solvent and flux will escape; the solid particles 16 will interact with the liquid 19. After cooling from reflow heating the microstructure of the solder will consist of uniformly distributed Bi-phase particles 20 in a γ phase eutectic matrix 21. The γ-phase is a Sn-In intermetallic phase with Bi in solid solution. The post reflow melting temperature is determined by the ratio of Sn/E₁ to achieve a temperature of about 160°C, the ratio is generally about 1 (E₁)/1 (Sn).

Table 1 lists other eutectics of the ternary and binary alloy system that may be used for the eutectic powder component; the table also lists the accompanying melting temperature, composition by weight percent, and the phases for each of said eutectics. Table 1 illustrates that (i) a solder paste consisting of Sn and E₂, E₃ or e₇ or e₄ powders, will reflow in the temperature range of 80-150°C, (ii) a solder paste consisting of pure Sn and one of the Bi-In binary eutectics, such as e₁, e₂, or e_{3,} will have a reflow temperature in the range of 80-150°C, (iii) a solder paste consisting of pure Sn and Sn-In eutectic (e₆), will have a reflow temperature in the range 140-180°C, (iv) a solder paste consisting of Sn-Bi (e₅) and Sn-In (e₆₎ eutectics will have a reflow temperature in the range 140-180°C. Any of the above solder pastes may be formulated to substitute Sn-Ag eutectic particles (96.5% Sn-3.5% Ag by weight) or Sn-10%In-95% Bi-0.5% Ag. in place of the Sn particles. Furthermore any of such previously mentioned soldered pastes may also be alloyed with additions of copper, nickel, silver, cerium, bismuth, indium and gold powders in small quantities which can be added to any of such combinations to further improve mechanical properties of the solder at elevated temperatures. These additional elements should be incorporated in an amount only up to 3% by weight of the solder, but not in an amount that would inhibit metallurgical interactions of the first and second powders at or less than 150°C in 15 minutes or less at such temperature.

A method of using the unique solder composition of this invention in a reflow soldering process to interconnect electronic components or packages to circuits on a thermoplastic substrate, would comprise the following steps: (a) The solder composition is formulated and prepared by admixing metal powders with a flux medium containing 85-95% by weight of the metal powders to form a paste. The solder will consist of dispensable material containing a low melting powder component comprised of a ternary or binary eutectic or alloy of the Sn-Bi-In system, and a high melting component comprising Sn. They are admixed in a ratio with the first component being 25-75% by weight of the admixture, to attain the desired post reflow melting temperature. The solvents, activators and surfactants may be as previously described. (b) The prepared solder paste is applied onto the faying surfaces of the electronic assembly to be soldered (the faying surfaces being typically a copper trace which is overlaid or cast in place on or in a 3-dimensional plastic moulded component or other polymeric or ceramic substrate). The dispensing is carried out by screen printing, stencilling or by syringe application or other dispensing methods. (c) The assembly, containing the deposited solder, is then heated in an oven to a temperature above the melting point of the low temperature metal powder constituent while being essentially below 150°C. The second powder component (Sn) interacts with the melted eutectic during reflow which promotes a higher post reflow melting temperature of the solder and thereby improve the mechanical properties of the solder joint.

**TABLE 1**

| Sn-Bi-In Ternary Eutectic and Bi-In, Sn-In, Sn-Bi Binary Eutectic Compositions | | | |
|---|---|---|---|
| Eutectic | Eutectic Temperature | Composition (wt.%) | Phases, Melting Temperature and Solid Solubility Ranges |
| E₁ | 350.5K | 18.0Sn | Bi ( 271.4C) |
| | 77.5C | 57.2Bi | BiIn (110C) |
| | | 24.8In | γ (Sn-In) (120-224C) |
| | | | (73.5-85.5 wt. % Sn) |
| E₂ | 332K | 16.5Sn or 19.6 | β (In-Sn) (120-149C) |
| | 59C | 32.5Bi | (12.4-44.8 wt.%Sn) |
| | | 31.6 | BiIn₂ (89.5C) |
| | | 51.0In | γ (Sn-In) (120-224C) |
| | | 48.8 | |
| E₃ | 329.5K | 10.0Sn | Bi₃In₅ (88.9C) |
| | 56.5C | 45.2Bi | BiIn₂ (89.5C) |
| | | 44.8In | γ (Sn-In) (120-224C) |
| | | (approximate) | |
| | | | |
| e₇ | 335K | 13.5Sn | γ |
| | 62C | 42.0Bi | BiIn₂ |
| | | 44.5In | |
| e₄ | 359K | 15Sn | γ |
| | 86C | 55Bi | BiIn |
| | | 30In | |
| | | (approximate) | |
| e₁ | 382.7K | 67.4Bi | Bi (271.4C) 0-0.005 |
| | 109.7C | 32.6In | wt. % In |
| | | | BiIn (110C) 35.4 wt% n |
| e₂ | 361.7K | 50Bi | Bi₃In₅ (88.9C) 47.5- |
| | 88.7C | 50In | 47.97 |
| | | | wt. % In |
| | | | BiIn₂ (89.5C) 52.5- |
| | | | 53.5 |
| | | | wt. % In |
| e₃ | 345.7K | 33.3Bi | BiIn₂ (89.5C) 52.5-53.5 |
| | 72.7C | 66.7In | |
| | | | wt. % In |
| | | | In (156.6C) 86-100 |
| | | | wt. % In |
| e₆ | 393K | 49.1Sn | γ (224C) 73-85 (appr.) |
| | 120C | 50.9In | wt. % Sn |
| | | | β (130C) 12.4-448 |
| | | | wt. % Sn |
| e₅ | 412K | 43.0Sn | Sn (232C) 0-21 |
| | 139C | 57.0Bi | wt. %Bi |
| | | | Bi (271.4C) 0-0.1 |
| | | | wt. % Sn |

## Claims

1. A solder composition for soldering electronic components and packages (11) to a printed circuit substrate (12,13) consisting of a low cost thermoplastic or polymer selected from polypropylene, nylon, polycarbonate, acrylonitride butadiene styrene, polyethylene terephthalate, polypropylene oxide and polymethylstyrene, each of which has a heat deflection temperature in the range 100 to 150°C, such solder composition being formed as a paste by use of a fugitive carrier medium including a fugitive flux and comprising:
(a) a first powder component consisting of a ternary or binary eutectic or alloy of the system Sn-Bi-In having a eutectic temperature either below 100°C or between 100°C and 150°C, and
(b) a second powder component selected from the group of Sn, Sn-3.5% Ag, and Sn-10%In-9.5%Bi-0. 5%Ag and capable of reacting with the first powder component at ≤ 150°C in ≤ 15 min to form solid solutions intermetallics and therby raise the post reflow soldering temperature, admixed with the first powder component, the weight ratio of the first powder to the second powder in the composition being 1:3 to 3:1, and, optionally,
(c) other alloying additions selected from the group Cu, Ni, Ag, Ce, In, Bi and Au, said alloying additions being limited to 3% by weight of the solder.

2. The composition as in claim 1, in which the first powder component is selected from the eutectics E₁, E₂, E₃, e₇, e₄, e₂, e₃, each having a eutectic temperature below 100°C.

3. The composition as claimed in claim 1 in which the first powder component is selected from eutectics e₁, e₆, e₅, each having a eutectic temperature in the range 100°C to 150°C.

4. The composition as claimed in any one of the preceding claims in which the particle size for each of the first and second powders is -200/+325 mesh.

5. The composition as claimed in any one of the preceding claims containing less than 0.1% of Pb by weight of the composition.

6. A method of reflow soldering electronic components or packages (11) to a printed circuit substrate (12,13) consisting of a low cost thermoplastic or polymer selected from polypropylene, nylon, polycarbonate, acrylonitride butadiene styrene, polyethylene terephthalate, polypropylene oxide and polymethylstyrene, each of which has a heat deflection temperature in the range 100 to 150°C comprising the steps of:
(a) applying the solder paste as defined in anyone of claims 1-5 onto a faying surface of the substrate circuit; and
(b) heating the assembly to a temperature above the melting point of the eutectic powder to react Sn with the melted eutectic to form solid solutions intermetallics and thereby raise the post reflow soldering temperature of the solder to improve mechanical properties of the soldered joint when in service.

## Patentansprüche

1. Eine Lotzusammensetzung zum Anlöten elektronischer Bauteile und Baugruppen (11) an ein aus einem billigen Thermoplast oder Polymer bestehendes, gedrucktes Schaltungssubstrat (12, 13), ausgewählt aus Polypropylen, Nylon, Polycarbonat, Acrylonitrid-Butadienstyrol, Polyethylen-Terephtalat, Polypropylenoxid und Polymethylstyrol, von denen jedes eine Wärmedurchbiegungs-Temperatur im Bereich 100-150°C aufweist, wobei eine derartige Lotzusammensetzung unter Verwendung eines - ein flüchtiges Flußmittel einschließenden - flüchtigen Trägermediums gebildet wird und umfaßt:
(a) eine erste Pulverkomponente, bestehend aus einem ternären oder binären Eutektikum oder einer Legierung des Systems Sn-Bi-In, das eine Eutektikumstemperatur entweder unterhalb 100°C oder zwischen 100°C und 150°C besitzt; und
(b) eine zweite Pulverkomponente, ausgewählt aus der Gruppe aus Sn, Sn - 3,5% Ag, und Sn - 10% In - 9,5% Bi - 0,5% Ag, und in der Lage mit der ersten Pulverkomponente bei ≤150°C in ≤15 min. zu reagieren, um feste intermetallische Lösungen zu bilden und dadurch die Temperatur nach dem Aufschmelzlöten zu erhöhen; zusammengemischt mit der ersten Pulverkomponente, wobei das Gewichtsverhältnis des ersten Pulvers zu dem zweiten Pulver in der Zusammensetzung 1:3 bis 3:1 beträgt, und optional
(c) andere legierende Zusätze, ausgewählt aus der Gruppe Cu, Ni, Ag, Ce, In, Bi und Au, wobei dieses legierenden Zusätze auf 3 Gewichtsprozent des Lots beschränkt sind.

2. Die Zusammensetzung gemäß Anspruch 1, in welcher die erste Pulverkomponente aus den Eutektika E₁, E₂, E₃, e₇, e₄, e₂, e₃ ausgewählt ist, die jedes eine Eutektikumstemperatur unterhalb 100°C aufweisen.

3. Die Zusammensetzung gemäß Anspruch 1, in welcher die erste Pulverkomponente aus den Eutektika e₁, e₆, e₅ ausgewählt ist, die jedes eine Eutektikumstemperatur im Bereich von 100-150°C aufweisen.

4. Die Zusammensetzung gemäß einem der vorstehenden Ansprüche, in welchem die Partikelgröße für jedes der ersten und zweiten Pulver -200/+325 Mesh beträgt.

5. Die Zusammensetzung gemäß einem der vorstehenden Ansprüche, die weniger als 0,1 Gewichtsprozent der Zusammensetzung als Pb enthält.

6. Ein Verfahren des Aufschmelzlötens elektronischer Bauteile oder Baugruppen (11) an ein aus einem billigen Thermoplast oder Polymer bestehendes, gedrucktes Schaltungssubstrat (12, 13), ausgewählt aus Polypropylen, Nylon, Polycarbonat, Acrylonitrid-Butadienstyrol, Polyethylen-Terephtalat, Polypropylenoxid und Polymethylstyrol, von denen jedes eine Wärmedurchbiegungs-Temperatur im Bereich 100-150°C aufweist, das die Schritte umfaßt:
(a) Aufbringen der Lotpaste - wie in irgendeinem der Ansprüche 1-5 beschrieben - auf einer Paßfläche der Substratschaltung; und
(b) Aufheizen des Aufbaus auf eine Temperatur oberhalb des Schmelzpunktes des eutektischen Pulvers, um Sn mit dem geschmolzenen Eutektikum reagieren zu lassen, um feste intermetallische Lösungen zu bilden und dadurch die Temperatur des Lots nach dem Aufschmelzlöten zu erhöhen, um mechanische Eigenschaften der gelöteten Verbindung zu verbessern wenn sie sich im Gebrauch befindet.

## Revendications

1. Composition de soudure destinée à souder des composants et des boîtiers électroniques (11) à un substrat à circuit imprimé (12, 13) constitué d'un thermoplastique ou d'un polymère de faible coût choisis parmi un polypropylène, un nylon, un polycarbonate, un acrylonitrile-butadiène-styrène, un polytérephtalate d'éthylène, un polyoxyde de propylène et un polyméthylstyrène, dont chacun présente une température de fléchissement à chaud dans la plage de 100 à 150°C, une telle composition de soudure étant réalisée sous forme d'une pâte grâce à l'utilisation d'un milieu de support volatil comprenant un flux volatil et comprenant :
(a) un premier composant de poudre constitué d'un eutectique ou d'un alliage ternaire ou binaire du système Sn-Bi-In présentant une température eutectique soit au-dessous de 100°C, soit entre 100°C et 150°C, et
(b) un second composant de poudre choisi parmi le groupe constitué de Sn, Sn-3,5 % de Ag et Sn-10 % de In-9,5 % de Bi-0,5 % de Ag et capable de réactions avec le premier composant de poudre à ≤ 150°C en ≤ 15 min pour former dès composés intermétalliques en solutions solides et élever ainsi la température après soudage par refusion, en admixtion avec le premier composant de poudre, le rapport massique de la première poudre sur la seconde poudre dans la composition étant de 1:3 à 3:1, et, facultativement,
(c) d'autres additions d'alliage choisies parmi le groupe Cu, Ni, Ag, Ce, In, Bi et Au, lesdites additions d'alliage étant limitées à 3 % en poids de la soudure.

2. Composition selon la revendication 1, dans laquelle le premier composant de poudre est choisi parmi les eutectiques E₁, E₂, E₃, e₇, e₄, e₂, e₃, chacun présentant une température eutectique au-dessous de 100°C.

3. Composition selon la revendication 1, dans laquelle le premier composant de poudre est choisi parmi les eutectiques e₁, e₆, e₅, chacun présentant une température eutectique dans la plage de 100°C à 150°C.

4. Composition selon l'une quelconque des revendications précédentes, dans laquelle la taille de particules pour chacune des première et seconde poudres est de -200/+325 meshs.

5. Composition selon l'une quelconque des revendications précédentes, contenant moins de 0,1 % de Pb en poids de la composition.

6. Procédé de soudage par refusion de composants ou de boîtiers électroniques (11) sur un substrat à circuit imprimé (12, 13) constitué d'un thermoplastique ou d'un polymère de faible coût choisi parmi un polypropylène, un nylon, un polycarbonate, un acrylonitrile-butadiène-styrène, un polytérephtalate d'éthylène, un polyoxyde de propylène et un polyméthylstyrène, dont chacun présente une température de fléchissement à chaud dans la plage de 100 à 150°C, comprenant les étapes consistant à :
(a) appliquer la pâte de soudure selon l'une quelconque des revendications 1 à 5 sur une surface affleurante du substrat à circuit, et
(b) chauffer l'ensemble à une température au-dessus du point de fusion de la poudre eutectique afin de faire réagir Sn avec l'eutectique fondu pour former des composés intermétalliques en solutions solides et élever ainsi la température après soudage par reflux de la soudure pour améliorer les propriétés mécaniques de la jonction soudée lorsqu'elle en service.
